Europäisches Patentamt

European Patent Office

Office européen des brevets

(11) Publication number: 0 292 959 B1

# EUROPEAN PATENT SPECIFICATION

(45) Date of publication of patent specification: 02.03.94   (51) Int. Cl.⁵: H01L 39/14, H01L 39/24

(21) Application number: 88108407.3

(22) Date of filing: 25.05.88

(54) **Superconducting member.**

(30) Priority: 26.05.87 JP 128587/87

(43) Date of publication of application:
30.11.88 Bulletin  88/48

(45) Publication of the grant of the patent:
02.03.94 Bulletin  94/09

(84) Designated Contracting States:
DE FR GB

(56) References cited:
EP-A- 0 129 686
EP-A- 0 285 445
EP-A- 0 286 014
FR-A- 2 469 005

THIN SOLID FILMS, vol. 54, 1978, pages
129-136, Elsevier Sequoia S.A., Lausanne,
CH; L.R. GILBERT et al.: "Superconducting
BaPb1-xBixO3 ceramic films prepared by
R.F. sputtering"

(73) Proprietor: SUMITOMO ELECTRIC INDUSTRIES
LIMITED
No. 15, Kitahama 5-chome,
Higashi-ku
Osaka-shi, Osaka 541(JP)

(72) Inventor: Takano, Satoshi c/o Osaka Works of
Sumitomo Electric Ind. Ltd
1-3, Shimaya 1-chome
Konohana-ku Osaka(JP)

(74) Representative: KUHNEN, WACKER & PART-
NER
Alois-Steinecker-Strasse 22
D-85354 Freising (DE)

JAPANESE JOURNAL OF APPLIED PHYSICS/PART 2, LETTERS, vol. 26, no. 4, April 1987, pages L388-L390, Tokyo, JP; M. KAWASAKI et al.: "Compositional and structural analyses for optimizing the preparation conditions of superconducting $(La_{1-x}Sr_x)_yCuO_{4-\delta}$ films by sputtering"

NATURE, vol. 326, 30th April 1987, pages 857-859; R.E. SOMEKH et al.: "High superconducting transition temperatures in sputter-deposited YBaCuO thin films"

ADVANCED CERAMIC MATERIALS- CERAMIC SUPERCONDUCTORS, vol. 2, no. 3B, July 1987, pages 411-421, ACerS, Westerville, OH, US; W.T. ELAM et al.: "Plasma sprayed high Tc superconductors"

JOURNAL OF MATERIAL RESEARCH, vol. 2, no. 6, November/December 1987, pages 713-725, Materials Research Society, US; M. NAITO et al.: "Thin-film synthesis of the high-Tc oxide superconductor $YBa_2Cu_3O_7$ by electron-beam codeposition"

JOURNAL OF APPLIED PHYSICS, vol. 63, no. 9, 1st May 1988, pages 4591-4598, American Institute of Physics; T. VENKATESAN et al.: "Substrate effects on the properties of Y-Ba-Cu-O superconducting films prepared by laser deposition"

Japanese Journal of Applied Physics/Part 2, Letters, Vol. 26, No. 4, April 1987, pages L 508 - L 509 and L 521 - L 523, Tokyo, JP

AIP Conference Proceedings, No 165, pages 427 - 434, edited by Harper et al., November 1987

Extended Abstracts for the Materials Research Society Symposium on High-Temperature Superconductors, Anaheim, California, 23, 24 April 1987; pages 169-171

## Description

The present invention relates to the structure of a superconducting member, and more particularly, it relates to the structure of a superconducting member having excellent superconductivity, which is formed by using a base material.

In recent years, oxide superconducting materials having perovskite structure, such as those of La-Sr-Cu-O and Y-Ba-Cu-O, have been discovered in succession. Since such discovery, many studies have been made on these materials, which are higher in critical temperature than conventional superconducting materials such as alloys or intermetallic compounds of Nb-Ti, Nb-Ge and the like.

An oxide superconducting material is manufactured/worked mainly by powder sintering at present. For example, a superconducting wire rod is provided by filling powder of an oxide superconducting material in a metal pipe and performing wire drawing. In order to form a circuit, there has been proposed a method of kneading powder of an oxide superconducting material with an organic binder and printing the same. In either method, the powder is shaped into a linear or layer member, to be finally sintered. Thus, the powder member is inevitably shrunk in sintering, and hence it is difficult to obtain a final product in arbitrary configuration or size.

Every oxide superconductor heretofore discovered has high crystal anisotropy, and it is necessary to orient its crystal in order to obtain high critical current density. However, it is difficult to provide high orientation by sintering. Further, voids are inevitably defined by sintering, and hence it has been impossible to obtain an oxide superconductor having satisfactory critical current density by sintering.

On the other hand, an oxide superconductor having an arbitrary configuration can be easily obtained by a method of preparing a base material with excellent workability for forming a superconducting film on the same, dissimilarly to the sintering process. In particular, such a superconducting film can be made by a vapor phase film process such as sputtering, which is excellent in crystal controllability to easily obtain a dense film, as effective means for obtaining a superconductor having excellent properties.

In the case of forming a thin film on the base material, however, heatlng in an oxidizing atmosphere is required for performing heat treatment after film formation or for heating the substrate during film formation. Thus, superconductivity is easily reduced by oxidation of the base material or diffusion between a superconducting layer and the base material. In the method of forming a thin film on the base material, therefore, the base material is restricted to a high-priced material which is hard to work, such as $SrTiO_3$ or MgO.

Extended Abstracts for the Materials Research Society Symposium on High-Temperature Superconductors, Anaheim, California, 23, 24 April 1987; pages 169 to 171 discloses a superconducting thin films consisting of YBaCuO which is formed on a $ZrO_2$ buffer layer. The $ZrO_2$ is formed on an $Al_2O_3$ substrate. EP-A-0 129 686 discloses $NbC_xN_yO_z$ as a superconductor second film, a $ZrO_2$ first film and a substrate of steel.

EP-A-0 286 014 falling within the terms of Article 54(3) EPC discloses a wire of steel coated with a ceramic layer and a YBaCuO-layer on the ceramic layer. EP-A-0 285 445 falling within the terms of Article 54(3) EPC discloses a semiconductor substrate, a ceramic first film and a superconducting second film. AIP Conference Proceeding, No. 165, pages 427 - 434, edited by Harper et al., November 1987, discloses a superconducting member comprising a semiconductor substrate, a zirconium oxide first film and a second film of a superconductor containing copper ions.

Particularly, formation of an oxide superconducting film on a metal base material has been studied, but this base material is extremely oxidized and remarkable influence is exerted by diffusion between the superconducting layer and the base material. However, when a superconducting material is applied to an elongated member such as a tape, for example, it is preferable to employ a highly flexible metal substrate as a base material. Thus, awaited is further means for forming an oxide superconducting layer on a metal base material.

An object of the present invention is to provide a superconducting member having excellent superconductivity, which can be formed by using a substrate of an arbitrary base material of the group consisting of a metal, an alloy and a semiconductor and which member is adapted to prevent diffusion between the substrate (base material) and the superconductor.

A superconducting member in accordance with the present invention comprises a substrate of a base material having a major surface consisting of a metal, an alloy or a semiconductor, the semiconductor not being strontium titanate, a first film formed on said substrate including at least a single ceramic layer formed on said major surface of said base material, said ceramic layer consisting of strontium titanate; and a second film of an oxide superconductor formed on said first film, said oxide superconductor containing copper ions.

3

The first film formed on the major surface of the base material may include at least a single layer of structure having uniaxial orientation. Such uniaxial orientation may be C-axis orientation. Further, the first film may be formed by physical vapor deposition or chemical vapor deposition.

The second film may be formed by physical vapor deposition. The oxide superconductor forming the second film contains copper ions, and preferably, the material is in oxygen deficiency type perovskite structure. A preferable example of such a material is a Y-Ba-Cu-O oxide superconductor.

According to the present invention, the substrate (base material) basically serves as a support for a superconductor. Further, the base material is adapted to maintain the configuration and size of the superconductor, as well as to reinforce the superconductor. The base material further serves as a stabilizing material against heat and current, and hence the same preferably has high thermal and electrical conductivity. Although the metal or alloy base material is not particularly restricted in material, copper, copper alloy or stainless steel can be employed as a preferable metal material. Further, a semiconductor material can be prepared by silicon or the like, to provide the base material in accordance with the present invention.

The first film, including strontium titanate as a ceramic layer, provided on the base material is adapted to prevent oxidation of the base material as well as to prevent diffusion between the base material and the superconductor.

The term "ceramics" is generally defined as a nonmetal inorganic solid material. The ceramic layer consisting of strontium titanate prevents oxidation of base materials, being prepared by metal and semiconductor materials, as well as prevents diffusion between the base materials and superconductors.

As a ceramic material effective in the first film of the present invention strontium titanate ($SrTiO_3$) is employed in view of its stability in a high-temperature oxidizing atmosphere.

The first film including the ceramic layer of strontium titanate can be formed by a vapor phase film process such as vapor deposition, sputtering, chemical vapor deposition or the like. The first film can be formed by applying oxide powder, being kneaded with an organic binder, on the base material and firing the same. The first film including said ceramic layer is not particularly restricted in thickness. In order to completely cover the surface of the base material and prevent diffusion, thickness of the first film including said ceramic layer may be at least 0.3 $\mu$m. If the base material has a smooth surface, thickness of the film including the ceramic layer may be 0.02 $\mu$m, to attain an effect according to the present invention. Such thickness is preferably not more than 3 $\mu$m in use requiring flexibility, since cracking is easily caused by bending if the thickness is increased. The first film may be formed by at least a single ceramic layer of strontium titanate having the aforementioned function, or as a film having multilayer structure.

In the oxide superconductor employed in the present invention, it is indispensable to improve orientation in order to increase crystal anisotropy and obtain high current density. According to the present invention, orientation of the first film including the ceramic layer, serving as a substrate for the second film of the superconductor, is so controlled as to also control orientation of the second film of the superconductor. In the first film including the ceramic layer, relatively high orientation can be obtained depending on orientation of the base material and film forming conditions. For example, the first film formed on the surface of a metal base material of copper can be provided with excellent orientation, and a superconductor formed thereon has high critical current density. If 80 percent by volume of the first (ceramic) film is uniaxially oriented particularly in the C-axis direction in three-dimensional space lattice, orientation of a superconductor formed thereon is extremely increased.

The second film of the superconductor in the present invention is preferably manufactured by sputtering performed while heating the substrate to obtain the film of the superconductor at a relatively low temperature, since the first (ceramic) film is reactive under a high temperature.

These and other objects, feature, aspects and advantages of the present invention will become more apparent from the following detailed description of the present invention when taken in conjunction with the accompanying drawings.

Fig. 1 is a sectional view showing a superconducting tape in accordance with an embodiment of the present invention; and

Fig. 2 is a sectional view showing a superconducting wire in accordance with another embodiment of the present invention.

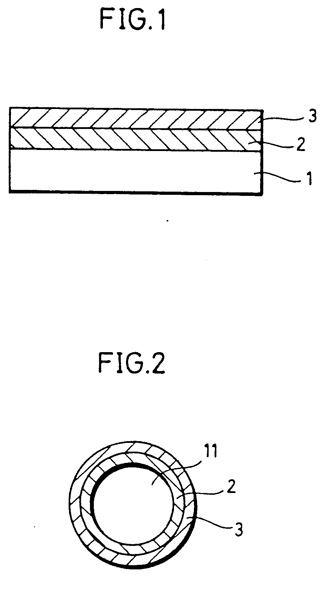

Fig. 1 is a sectional view showing a superconducting tape in accordance with an embodiment of the.present invention. Referring to Fig. 1, a metal tape 1 serving as substrate (base material) is provided thereon with a first (ceramic) film 2 and a second film 3 of an oxide superconductor having.perovskite structure in seguence.

Fig. 2 is a sectional view showing a superconducting wire in accordance with another embodiment of the present invention. Referring to Fig. 2, a metal wire 11 serving as substrate (base material) is provided on its outer peripheral surface with a first (ceramic) film 2 and a second film 3 of an oxide superconductor having perovskite structure.

Description is now made on Example 1 of a superconducting tape provided in accordance with the present invention. The reference Examples 1 to 11 (cf. Table I) not being embodiments of the present invention are useful in illustrating the present invention.

Example 1 and Reference Examples 1 to 11

Samples of superconducting tapes were prepared by tapes formed by base (parent) materials of copper and Ti films of 1 $\mu$m in thickness provided on the surfaces thereof (shown as "1 $\mu$mTi/Cu" in Table 1), tapes of SUS304 stainless steel and that of Cu-Ni alloy, which were provided thereon with first (ceramic) films as listed in Table 1 by plasma CVD process or ion plating. Further, thin second films of $Y_1 Ba_2 Cu_3 O_x$ were formed on the tapes by sputtering. Sputtering was performed by: (1) a method of forming a film by heating the substrate to a temperature of 800°C; and (2) a method of forming a film under the standard (ordinary) temperature and performing heat treatment in the atmosphere at a temperature of 950°C.

For the purpose of comparison, thin films of oxide superconductor similar to those of Reference Example 5 were respectively formed on a substrate (tape) of Cu and those of SUS304 stainless steel directly by sputtering.

Table 1 shows properties of superconducting tapes thus obtained.

Table 1

| | | substrate (tape material) | tape thickness (mm) | material for first (ceramic thin) film | thickness of first film (μm) | thickness of second $(Y_1BA_2Cu_3O)x$ film (μm) | sputtering | $T_C$ (°K) | flexibility* |
|---|---|---|---|---|---|---|---|---|---|
| Example | 1 | SUS304 | 0.2 | $SrTiO_3$ | 1 | 1 | (2) | 92 | o |
| Reference Example | 1 | Cu | 0.1 | | | 3 | (1) | non-super-conductive | – |
| Reference Example | 2 | SUS304 | 0.2 | | | 3 | (1) | non-super-conductive | – |
| Reference Example | 3 | SUS304 | 0.2 | | | 3 | (1) | non-super-conductive | – |
| Reference Example | 4 | SUS304 | 0.2 | | | 3 | (1) | 31 | non-super-conductive |
| | 5 | 1 μmTi/Cu | 0.1 | $Al_2O_3$ | 1 | 0.5 | (1) | 65 | o |
| | 6 | 1 μmTi/Cu | 0.1 | $M_gO$ | 1 | 0.5 | (1) | 72 | o |
| | 7 | 1 μmTi/Cu | 0.1 | $ZrO_2$ | 0.3 | 1 | (1) | 90 | o |
| | 8 | 1 μmTi/Cu | 0.1 | $ZrO_2$ | 2 | 1 | (1) | 88 | o |
| | 9 | SUS304 | 0.2 | $ZrO_2$ | 1 | 1 | (2) | 87 | o |
| | 10 | SUS304 | 0.2 | $TiO_2$ | 1 | 1 | (2) | 82 | o |
| | 11 | Cu-Ni | 0.25 | TiN | 1 | 2 | (1) | 51 | o |

*: wound on a rod of 10 mm in thickness and bent for measurement of zero resistance temperature $T_C$

o: $T_C$ change less than 1 deg.

As obvious from Table 1, it has been understood that the second (outermost) film of the superconductor had a high critical temperature while the superconducting tape was excellent in flexibility. Reference example 4, being formed by the second film of oxide superconductor directly provided on the surface of the metal substrate, superconducted at a low critical temperature $T_C$, while the corresponding Reference Examples 1 to 3 were non-superconductive.

Further Reference Example not being an embodiment of the present invention

An $SiO_2$ film was formed on a silicon substrate by a sol-gel method. First, water and hydrochloric acid were added to an ethanol solution of tetraethoxysilane (silicon tetraethoxide) to prepare sol by hydrolysis. Then the silicon substrate was dipped in this sol to form a sol film on the substrate. Thereafter the silicon substrate was heated to a temperature of 500°C in the atmosphere, to cause gelation of the sol film. Such operation was repeated by 10 times, to form an $SiO_2$ film of about 0.2 $\mu$m in thickness on the silicon substrate.

A sample was prepared by forming an MgO film of 0.2 $\mu$m in thickness or an $Al_2O_3$ film of 0.2 $\mu$m in thickness on the silicon substrate provided with the $SiO_2$ film by RF magnetron sputtering. Film forming conditions were as follows:

target: MgO polycrystal or $Al_2O_3$ polycrystal of 100 mm in diameter

target-substrate distance: 50 mm

sputtering gas: Ar gas containing 10 vol.% of $N_2$ gas

pressure: $1 \times 10^{-2}$ Torr.

output: 75 W

film forming time: 1.5 to 2 hours.

It has been recognized by X-ray diffraction that the MgO film thus formed had strong C-axis orientation of (001). It has also been recognized that the $Al_2O_3$ film as formed had no uniaxial orientation.

A $Y_1Ba_2Cu_3O_x$ film of 1 $\mu$m in thickness was formed on the MgO film or the $Al_2O_3$ film, serving as a ceramic film, by the sputtering method (1) of Example 1. A film of the oxide superconductor thus obtained was subjected to measurement of zero resistance temperature $T_C$ and critical current density $J_C$.

The film of the oxide superconductor formed on the MgO film had a zero resistance temperature $T_C$ of 84 K and critical current density $J_C$ of 1000 A/cm$^2$ at the temperature of liquid nitrogen (77.3 K). On the other hand, the film of the oxide superconductor formed on the $Al_2O_3$ film had a zero resistance temperature $T_C$ of 61 K. A further reference example, being prepared by forming a film of an oxide superconductor directly on a silicon substrate with no formation of a first (ceramic) film, presented no superconductivity at the temperature of liquid helium (4.2 K).

According to the present invention as hereinabove described, the base material is worked into arbitrary configuration and size to perform the first films (ceramic coating), which is the technique generally employed nowadays, on its surface and the second film of an oxide superconductor is further formed on the same, thereby to obtain a superconducting member having excellent properties, the substrate (base material) of which is a metal, an alloy or a semiconductor.

Further, the present invention can be applied to a semiconductor element or a sensor with a semiconductor substrate, to attain a great effect. It is almost impossible to form a superconducting layer directly on a base material prepared by a metal. Thus, the greatest effect of the present invention is that the same can be employed for an applied product such as a superconducting tape or a superconducting wire in the field of energy, by preparing the base material by a flexible metal material.

## Claims

1. A superconducting member comprising:
   A substrate of a base material having a major surface consisting of a metal, an alloy or a semiconductor, the semiconductor not being strontium titanate;
   a first film formed on said substrate including at least a single ceramic layer formed on said major surface of said base material, said ceramic layer consisting of strontium titanate; and
   a second film of an oxide superconductor formed on said first film, said oxide superconductor containing copper ions.

2. A superconducting member in accordance with claim 1, wherein said base material contains stainless steel.

3. A superconducting member in accordance with claim 1 and/or 2, wherein said first film includes at least a single layer being in structure having uniaxial orientation.

4. A superconducting member in accordance with claim 3, wherein said uniaxial orientation is C-axis orientation.

**5.** A superconducting member in accordance with any of claims 1 - 4, wherein said oxide superconductor has oxygen deficiency type perovskite structure.

**6.** A superconducting member in accordance with claim 5, wherein said oxide superconductor includes a Y-Ba-Cu-O oxide superconductor.

**Patentansprüche**

**1.** Ein supraleitendes Element, umfassend:
Ein Substrat aus einem Grundmaterial mit einer Hauptoberfläche, die aus einem Metall, einer Legierung oder einem Supraleiter, wobei der Supraleiter nicht Strontiumtitanat ist, besteht,
einen ersten Film, der auf dem genannten Substrat gebildet ist, und wenigstens eine einzige keramische Schicht umfaßt, welche auf der genannten Hauptoberfläche des genannten Grundmaterials gebildet ist, wobei die genannte keramische Schicht aus Strontiumtitanat besteht, und
einen zweiten Film aus einem Oxidsupraleiter, der auf dem genannten ersten Film gebildet wird, wobei der genannte Oxidsupraleiter Kupferionen enthält.

**2.** Ein supraleitendes Element gemäß Anspruch 1, wobei das genannte Grundmaterial nichtrostenden Stahl enthält.

**3.** Ein supraleitendes Element gemäß Anspruch 1 und/oder 2, wobei der genannte erste Film wenigstens eine einzige Schicht mit einer Struktur, die eine uniaxiale Orientierung hat, einschließt.

**4.** Ein supraleitendes Element gemäß Anspruch 3, wobei die genannte uniaxiale Orientierung eine C-Achsen-Orientierung ist.

**5.** Ein supraleitendes Element gemäß einem der Ansprüche 1 - 4, wobei der genannte Oxidsupraleiter eine Struktur des Perovskittyps mit Sauerstoff-Fehlstellen hat.

**6.** Ein supraleitendes Element gemäß Anspruch 5, wobei der genannte Oxidsupraleiter einen Y-Ba-Cu-O-Oxidsupraleiter einschließt.

**Revendications**

**1.** Elément formant supraconducteur comprenant :
un substrat de matériau de base ayant une surface principale constituée d'un métal, d'un alliage ou d'un semiconducteur, le semi-conducteur n'étant pas du titanate de strontium.
un premier film appliqué sur ledit substrat comprenant au moins une seule couche de céramique appliquée sur ladite surface principale dudit matériau de base, ladite couche de céramique étant constituée de titanate de strontium; et
un second film d'un oxyde supraconducteur appliqué sur ledit premier film, ledit oxyde supraconducteur contenant des ions de cuivre.

**2.** Elément formant supraconducteur conformément à la revendication 1, dans lequel ledit matériau de base contient de l'acier inoxydable.

**3.** Elément formant supraconducteur conformément à la revendication 1 et/ou 2, dans lequel ledit premier film comprend au moins une seule couche dont la structure a une orientation uniaxe.

**4.** Elément formant supraconducteur conformément à la revendication 3, dans lequel ladite orientation uniaxe est une orientation d'axe C.

**5.** Elément formant supraconducteur conformément à l'une quelconque des revendications 1 - 4, dans lequel ledit oxyde supraconducteur a une structure de perovskite de type à insuffisance d'oxygène.

**6.** Elément formant supraconducteur conformément à la revendication 5, dans lequel ledit oxyde supraconducteur comprend un oxyde supraconducteur Y-Ba-Cu-O.

## FIG.1

## FIG.2